Europäisches Patentamt

European Patent Office

Office européen des brevets

(11) Veröffentlichungsnummer: **0 187 317**
**B1**

(12) # EUROPÄISCHE PATENTSCHRIFT

(45) Veröffentlichungstag der Patentschrift:
06.09.89

(51) Int. Cl.⁴: **G 01 K 7/20**, G 01 R 15/08

(21) Anmeldenummer: **85116022.6**

(22) Anmeldetag: **16.12.85**

(54) **Messanordnung mit Widerstandsmesswertgebern.**

(30) Priorität: **03.01.85 DE 3500089**

(43) Veröffentlichungstag der Anmeldung:
**16.07.86 Patentblatt 86/29**

(45) Bekanntmachung des Hinweises auf die Patenterteilung:
**06.09.89 Patentblatt 89/36**

(84) Benannte Vertragsstaaten:
**CH DE FR GB LI NL SE**

(56) Entgegenhaltungen:
**EP-A- 0 120 102**
**DE-B- 1 566 787**

**ELEKTRONIK, Nr. 7, Juli 1966, Seiten 209-211; D. METZNER "Ein digitaler Temperatur-Sollwerteinsteller"**
**idem**

(73) Patentinhaber: **Siemens Aktiengesellschaft, Wittelsbacherplatz 2, D-8000 München 2 (DE)**

(72) Erfinder: **Breunig, Hans, Dipl.-Ing., Reinhold-Schneider-Strasse 25, D-7500 Karlsruhe (DE)**
Erfinder: **Klumpp, Wolfgang, Kappelgasse 5, D-7590 Achern-Mösbach (DE)**

Beschreibung

Die Erfindung betrifft eine Messanordnung mit Widerstandsmesswertgebern gemäss dem Oberbegriff des Anspruchs 1. Siehe z.B. EP-A1 0 120 102.

Ähnliche Messanordnungen sind aus der DE-B 1 566 787 bekannt. Sie enthalten einen Messstellenwähler, über welchen die einzelnen Widerstandsmesswertgeber an eine Konstantstromquelle gelegt werden können. Der dabei auftretende Spannungsabfall wird als Messspannung ebenfalls über den Messstellenwähler einem Messspannungsempfänger zugeführt. In einer ersten Schaltung mit jeweils drei Kontakten des Messstellenwählers je Messwertgeber tritt das Problem auf, dass die Messspannung über dieselben Kontakte geführt wird wie der Strom der Konstantstromquelle, so dass der Spannungsabfall an den Kontaktwiderständen sich der Messspannung überlagern und diese verfälschen kann. In einer anderen Schaltung ist dieses Problem dadurch vermieden, dass Speisestrom und Messspannung über verschiedene Kontakte geführt sind. Dies hat aber den Nachteil, dass je Messstelle fünf Kontakte benötigt werden.

Aus der EP-A1 0 120 102 ist es bekannt, die einen Anschlüsse von Messwiderständen miteinander und mit dem einen Pol einer Konstantstromquelle zu verbinden, während der andere Pol der Konstantstromquelle über einen Messstellenschalter wahlweise mit dem anderen Anschluss eines Messwiderstandes verbunden werden kann. Die Spannungen an den Messwiderständen werden unmittelbar an diesen abgenommen und über zwei weitere Kontakte einem Verstärker zugeführt, an dem eine Auswerteeinheit angeschlossen ist. In dieser bekannten Schaltung sind je Messwiderstand drei Kontakte erforderlich. Eine Überwachung auf Kurzschluss oder Drahtbruch in den Messwiderständen ist nicht vorgesehen.

In der US-A 3 534 353 ist eine Schaltungsanordnung beschrieben, mit der das Überschreiten von Stromgrenzen überwacht werden kann. Hierzu ist an die zu überwachende Stromquelle eine Reihenschaltung von Widerständen angeschlossen. Der Spannungsabfall an jedem Widerstand ist einem Schwellwertkomparator zugeführt, der den Spannungsabfall mit einer Referenzspannung vergleicht und bei Überschreiten des Schwellwertes ein Alarmsignal abgibt. Die Komparatoren sind voneinander galvanisch getrennt und ihre Eingänge sind so ausgebildet, dass ihr Eingangsstrom in die Reihenschaltung der Widerstände zurückfliesst, so dass die Belastung der Reihenschaltung von der Anzahl der Komparatoren unabhängig ist. Die Widerstandswerte sind im Gegensatz zu denen von Messwertgebern konstant und bekannt. Die an ihnen auftretenden Spannungen ändern sich gleichsinnig und im gleichen Verhältnis, im Gegensatz zu Messanordnungen mit Messwertgebern.

Der vorliegenden Erfindung liegt die Aufgabe zugrunde, eine Messanordnung mit mehreren Widerstandsmesswertgebern zu schaffen, die je Messwertgeber nur zwei Zuleitungen und damit zwei Messstellenwählerkontakte erfordert.

Erfindungsgemäss wird diese Aufgabe dadurch gelöst, dass die Widerstandsmesswertgeber unter sich und mit der Konstantstromquelle in Reihe geschaltet sind und die Weiterverarbeitungseinrichtung einen potentialfreien Eingang besitzt. Die Stromquelle wird also nicht mehr geschaltet, sondern es fliesst ständig ein Strom durch alle Messwertgeber. Geschaltet werden nur noch die einzelnen, an den Messwertgebern abfallenden Messspannungen, die über den Messstellenwähler dem Messspannungsempfänger, z.B. einem Analog-Digital-Umsetzer, zugeführt sind. Hierfür genügen zweipolige Relais. Wegen der Reihenschaltung befinden sich die Widerstandsgeber zwar auf unterschiedlichem Potential, dies bedeutet aber keinen Nachteil, da der Messspannungsempfänger ohnedies im allgemeinen einen potentialfreien Differenzeingang hat. Ausserdem kann die Konstantstromquelle aus einem beliebigen Netz, z.B. dem 24-Volt-Versorgungsnetz der Automatisierungsanlage, in welcher die Messanordnung eingesetzt ist, versorgt werden. Ausser der Einsparung an Leitungen und Messstellenwählerkontakten hat die erfindungsgemässe Anordnung den Vorteil, dass beim Aufschalten der Konstantstromquelle die dynamischen Probleme, wie sie z.B. in bekannten Schaltung bei langen Leitungen auftreten, entfallen. Ferner ergeben sich Möglichkeiten zur einfachen Überwachung der Konstantstromquelle sowie der Widerstandsgeber und der Leitungen auf Unterbrechung.

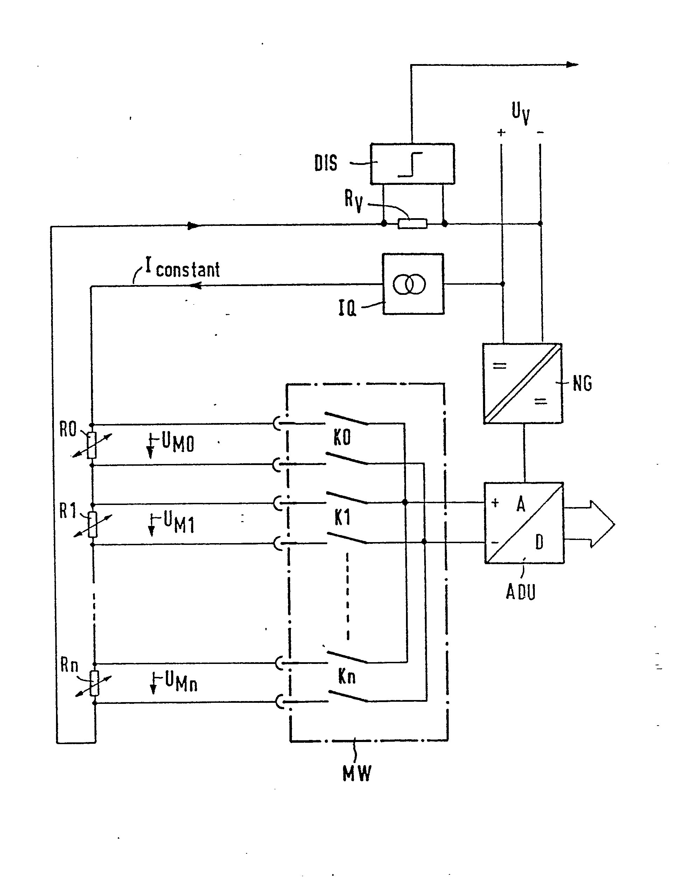

Anhand der Zeichnung werden im folgenden die Erfindung sowie weitere Vorteile und Ergänzungen näher beschrieben und erläutert.

Mit R0, R1 ... Rn sind Widerstandsmesswertgeber bezeichnet, die unter sich und mit einer Konstantstromquelle $I_Q$ in Reihe geschaltet sind. Die an ihnen abfallenden Messspannungen $U_{M0}$, $U_{M1}$ ... $U_{Mn}$ liegen über je eine zweiadrige Leitung an einem Messstellenwähler MW mit jeweils einem Kontaktpaar K0, K1 ... Kn je Widerstandsgeber. Mit ihnen kann je eine Messspannung auf einen Analog-Digital-Umsetzer ADU durchgeschaltet werden. Die an sich bekannte Anwähleinrichtung des Messstellenwählers ist, da nicht zur Erfindung gehörend, nicht dargestellt. Die Konstantstromquelle $I_Q$ wird, wie der Analog-Digital-Umsetzer ADU, aus einem Netzgerät NG gespeist, das eine Spannung $U_V$ abgibt, mit der auch weitere, nicht dargestellte Anlagenteile versorgt werden. Der Strom aus der Konstantstromquelle $I_Q$ fliesst von der Reihenschaltung der Widerstandsgeber R0, R1 ... Rn über einen Widerstand $R_V$ zurück zum Netzgerät NG. Der Spannungsabfall am Widerstand $R_V$ wird mit einem Diskriminator DIS überwacht. Im Falle einer Unterbrechung der Leitung oder eines Widerstandsgebers wird der Spannungsabfall Null, und der Diskriminator gibt ein Alarmsignal ab. Statt dessen kann auch die Ausgangsspannung der Konstantstromquelle $I_Q$ überwacht wer-

den. In diesem Falle wird ein Alarmsignal abgegeben, wenn die Ausgangsspannung einen vorgegebenen Betrag übersteigt.

Da der Konstantstrom stets fliesst und auch die Messspannungen ständig auf den Zuleitungen zum Messstellenwähler MW liegen, spielt beim Umschalten von einer Messspannung auf eine andere nur die Kapazität der kurzen Leitung zwischen den Messstellenwählerkontakten und dem Eingang des Analog-Digital-Umsetzers ADU eine Rolle. Dynamische Probleme können daher nicht mehr auftreten. Ausserdem kann jede Messspannung vor dem Messstellenwähler MW statisch abgegriffen und überwacht werden.

Im Ausführungsbeispiel werden die Messspannungen unmittelbar an den Widerstandsgebern abgenommen, damit der Spannungsabfall auf den Verbindungsleitungen zwischen den Widerstandsgebern die Messspannungen nicht beeinflussen kann. Ist jedoch dieser Spannungsabfall im Vergleich zur Messspannung ausreichend klein, kann die Anordnung dadurch weiter vereinfacht werden, dass zwischen je zwei Widerstandsgebern nur eine Messleitung angeschlossen ist und daher je Widerstandsgeber nur ein Messstellenwählerkontakt vorgesehen zu werden braucht. Die Messspannung an einem Widerstandsgeber wird dann dadurch bestimmt, dass die beiden an ihm anliegenden Messleitungen nacheinander vom Messstellenwähler mit dem Analog-Digital-Umsetzer-Eingang verbunden werden. Die Messspannung ist dann die Differenz der beiden ermittelten Spannungen.

## Patentanspruch

Messanordnung mit mehreren Widerstandsgebern (R0, R1 ... Rn), an denen bei Anschluss an eine Konstantstromquelle ($I_Q$) eine Messspannung ($U_{M0}$, $U_{M1}$ ... $U_{Mn}$) auftritt, die über einen Messstellenwähler (MW) einer Weiterverarbeitungseinrichtung (ADU) zuführbar ist, welche Weiterverarbeitungseinrichtung einen potentialfreien Eingang oder einen Differenzeingang besitzt, dadurch gekennzeichnet,
– dass die Widerstandsgeber (R0, R1 ... Rn) unter sich und mit der Konstantstromquelle ($I_Q$) in Reihe geschaltet sind
– dass die Ausgangsspannung der Konstantstromquelle ($I_Q$) auf Überschreiten eines Grenzwertes überwacht wird,
– dass vom Ausgangsstrom der Konstantstromquelle ($I_Q$) ein Widerstand ($R_V$) durchflossen ist, an den ein Diskriminator (DIS) angeschlossen ist, der ein Alarmsignal abgibt, wenn die Spannung am Widerstand ($R_V$) einen vorgegebenen Betrag unterschreitet.

## Claim

Measuring arrangement having several resistance-type sensors (R0, R1 ... Rn), at which with connection to a constant current source ($I_Q$) there occurs a measuring voltage ($U_{M0}$, $U_{M1}$ ... $U_{Mn}$) which can be fed by way of a measuring point selector (MW) to a further processing device (ADU) which has a potential-free input or a differential input, characterised
– in that the resistance-type sensors (R0, R1 ... Rn) are connected in series one with the other and with the constant current source ($I_Q$),
– in that the output voltage of the constant current source ($I_Q$) is monitored for exceeding of a limiting value,
– in that the output current of the constant current source ($I_Q$) flows through a resistor ($R_V$) to which there is connected a discriminator (DIS) which emits an alarm signal when the voltage at the resistor ($R_V$) falls below a preset amount.

## Revendication

Dispositif de mesure comportant plusieurs capteurs à résistances (R0, R1, ... Rn), au niveau desquels apparaît, lors du raccordement à une source de courant constant ($I_Q$), une tension de mesure ($U_{M0}$, $U_{M1}$ ... $U_{Mn}$), qui peut être envoyée, par l'intermédiaire d'un sélecteur (MW) de positions de mesure, à un dispositif de post-traitement (ADU), qui possède une entrée à potentiel libre ou une entrée différentielle, caractérisé par le fait que
– les capteurs à résistances (R0, R1, ... Rn) sont raccordés en série entre eux ainsi qu'à la source de courant constant ($I_Q$),
– que la tension de sortie de la source de courant constant ($I_Q$) est contrôlée afin de déterminer si elle dépasse une valeur limite,
– que le courant de sortie de la source de courant constant ($I_Q$) traverse une résistance ($R_V$), à laquelle est raccordé un discriminateur (DIS), qui délivre un signal d'alarme lorsque la tension aux bornes de la tension ($R_V$) tombe au-dessous d'une valeur prédéterminée.